# EUROPEAN PATENT APPLICATION

(11) **EP 4 775 396 A1**
(43) Date of publication of application: **15.07.2026**
(21) Application number: 24862521.2
(22) Date of filing: 08.08.2024
(51) Int. Cl.: B41J 2/01, B05D 1/26, B05D 3/00, B41J 2/205

(54) **IMAGE FORMING DEVICE, IMAGE FORMING METHOD, AND IMAGE FORMING PROGRAM**

(30) Priority: 05.09.2023 JP 2023143541
(71) Applicant: Konica Minolta, Inc., Tokyo 100-7015 (JP)
(72) Inventor: KURAMOCHI, Shouhei, Chiyoda-ku, Tokyo 100-7015 (JP)
(74) Representative: MFG Patentanwälte Meyer-Wildhagen Meggle-Freund Gerhard PartG mbB
(86) International application number: PCT/JP2024/028552
(87) International publication number: WO 2025/052867

(57) **Abstract**

This image forming device comprises a head unit, and a control unit that performs a first operation and a second operation. When the number of the first operation is n (an integer equal to or greater than 2) times and the second operation of m × n times, moving in one direction to one side in a second direction, with respect to each pixel row formation region obtained by dividing a nozzle pitch corresponding region into m (an integer equal to or greater than 1) regions in the second direction, is performed, the control unit prohibits the discharge of the ink in at least one nozzle from an end portion side of the head unit in at least one first operation.

## Description

### Technical Field

The present invention relates to an image forming apparatus, an image forming method, and an image forming program.

### Background Art

Industrial printing is performed using an inkjet printing apparatus (image forming apparatus). For example, an inkjet printing apparatus is used to print a wiring pattern and the like on a printed circuit board (PCB) that serves as a recording medium. In an inkjet printing apparatus, there are some variations in the print length for each inkjet head (hereinafter, the inkjet head will be referred to as the head), and deviation of landing of ink due to such variations or the like may cause defects such as gaps and streaks in wiring patterns to be printed.

In order to prevent occurrence of a defect due to deviation of landing of ink, a printing method called block printing, which is one type of multi-pass printing, is generally performed (for example, Patent Literature (hereinafter referred to as "PTL") 1). In the block printing, an adjacent pixel adjacent to a printed pixel is printed by the same nozzle or a nozzle in the vicinity thereof in the head, and thus, the movement amount of the recording medium or the carriage of the head in the nozzle column direction is reduced. Thus, it is configured such that deviation of landing of ink due to variations in the print length for each head is suppressed. In a case where printing is performed with an image width equal to or greater than the print length of the head, it is configured in the block printing such that the recording medium or the carriage is fed by the number of heads × the print length.

### Citation List

### Patent Literatures

PTL 1
Japanese Patent Application Laid-Open No. 2022-72456

### Summary of Invention

### Technical Problem

There is a method called feathering or interleaving in which, in combination with the above-described block printing, pixel columns in a target region are not printed in one pass, but is printed in a plurality of passes. In the case of such a method, since pixel columns in a target region are printed in a plurality of passes, it is necessary to reverse the movement direction of the recording medium or the carriage. When the movement direction of the recording medium or the carriage is reversed, the movement accuracy of the recording medium or the carriage at the time of the reversal may deteriorate due to a structural play of the movement mechanism.

An object of the present invention is to provide an image forming apparatus, an image forming method, and an image forming program each capable of preventing deterioration in the movement accuracy of a recording medium or a carriage.

### Solution to Problem

An image forming apparatus according to the present invention includes:
a head section that causes a plurality of nozzles, which is arranged in a row at each nozzle pitch along a second direction orthogonal to a first direction, to discharge ink; and
a control section that causes a first operation, in which the ink is discharged while relatively moving a recording medium and the head section in the first direction, and a second operation, in which the recording medium and the head section are relatively moved in the second direction, to be repeatedly performed to perform control such that an image with the ink is formed in a nozzle pitch corresponding region of the recording medium, where the nozzle pitch corresponding region corresponds to the each nozzle pitch.

In a case where the first operation is performed n times, where n is an integer equal to or greater than 2, with respect to each of m pixel column formation regions obtained by dividing the nozzle pitch corresponding region into the m pixel column formation regions in the second direction, where m is an integer equal to or greater than 1, the control section prohibits discharge of the ink in at least one of the plurality of nozzles from a side of an end portion of the head section in at least one of a plurality of the first operations when the second operation in which the recording medium and the head section are moved in one direction to one side in the second direction is performed m × n times.

An image forming method according to the present invention is an image forming method including repeatedly performing, by an image forming apparatus including a head section that causes a plurality of nozzles, which is arranged in a row at each nozzle pitch along a second direction orthogonal to a first direction, to discharge ink, a first operation, in which the ink is discharged while relatively moving a recording medium and the head section in the first direction, and a second operation, in which the recording medium and the head section are relatively moved in the second direction, to form an image with the ink in a nozzle pitch corresponding region of the recording medium, where the nozzle pitch corresponding region corresponds to the each nozzle pitch.

In a case where the first operation is performed n times, where n is an integer equal to or greater than 2, with respect to each of m pixel column formation regions obtained by dividing the nozzle pitch corresponding region into the m pixel column formation regions in the second direction, where m is an integer equal to or greater than 1, discharge of the ink in at least one of the plurality of nozzles from a side of an end portion of the head section is prohibited in at least one of a plurality of the first operations when the second operation in which the recording medium and the head section are moved in one direction to one side in the second direction is performed m × n times.

An image forming program according to the present invention is an image forming program that causes a computer to execute, in an image forming apparatus including a head section that causes a plurality of nozzles, which is arranged in a row at each nozzle pitch along a second direction orthogonal to a first direction, to discharge ink, repeatedly performing a first operation, in which the ink is discharged while relatively moving a recording medium and the head section in the first direction, and a second operation, in which the recording medium and the head section are relatively moved in the second direction, to form an image with the ink in a nozzle pitch corresponding region of the recording medium, where the nozzle pitch corresponding region corresponds to the each nozzle pitch.

The image forming program causes the computer to execute, in a case where the first operation is performed n times, where n is an integer equal to or greater than 2, with respect to each of m pixel column formation regions obtained by dividing the nozzle pitch corresponding region into the m pixel column formation regions in the second direction, where m is an integer equal to or greater than 1, prohibiting discharge of the ink in at least one of the plurality of nozzles from a side of an end portion of the head section in at least one of a plurality of the first operations when the second operation in which the recording medium and the head section are moved in one direction to one side in the second direction is performed m × n times.

### Advantageous Effects of Invention

According to the present invention, it is possible to prevent deterioration of the movement accuracy of a recording medium or a carriage.

### Brief Description of the Drawings

Fig. 1 is a top surface diagram illustrating the main configuration of an image forming apparatus according to an embodiment of the present invention;
Fig. 2A is a diagram illustrating an example of the configuration of an inkjet head;
Fig. 2B is a diagram illustrating an example of the configuration of a carriage including the inkjet head illustrated in Fig. 2A;
Fig. 3A is a diagram illustrating another example of the configuration of the inkjet head;
Fig. 3B is a diagram illustrating another example of the configuration of the inkjet head;
Fig. 3C is a diagram illustrating another example of the configuration of the inkjet head;
Fig. 4A is a diagram provided for describing an image forming method in the related art, which describes first to fourth passes;
Fig. 4B is a diagram provided for describing the image forming method in the related art, which describes fifth to eighth passes;
Fig. 5A is a diagram provided for describing an image forming method according to the embodiment of the present invention, which describes first to fourth passes;
Fig. 5B is a diagram provided for describing the image forming method according to the embodiment of the present invention, which describes fifth to eighth passes;
Fig. 6 is a diagram provided for describing a state in which the intervals between pixel columns are not uniform in a case where there are variations in the print length for each inkjet head in general multi-pass printing;
Fig. 7A is a diagram provided for describing a variation (Variation 1) of the image forming method according to the embodiment of the present invention, which describes first to fourth passes;
Fig. 7B is a diagram provided for describing the variation (Variation 1) of the image forming method according to the embodiment of the present invention, which describes fifth to eight passes;
Fig. 8A is a diagram provided for describing another variation (Variation 2) of the image forming method according to the embodiment of the present invention, which describes first to third passes;
Fig. 8B is a diagram provided for describing the other variation (Variation 2) of the image forming method according to the embodiment of the present invention, which describes fourth to sixth passes;
Fig. 9A is a diagram provided for describing another variation (Variation 3) of the image forming method according to the embodiment of the present invention, which describes first to fourth passes;
Fig. 9B is a diagram provided for describing the other variation (Variation 3) of the image forming method according to the embodiment of the present invention, which describes fifth to eighth passes;
Fig. 10A is a diagram provided for describing another variation (Variation 4) of the image forming method according to the embodiment of the present invention, which describes first to fourth passes;
Fig. 10B is a diagram provided for describing the other variation (Variation 4) of the image forming method according to the embodiment of the present invention, which describes fifth to eight passes;
Fig. 11A is a diagram illustrating how ink to be discharged from each nozzle of the inkjet head is ejected so as to be narrowed inward; and
Fig. 11B is a diagram illustrating how ink to be discharged from each nozzle of the inkjet head is ejected so as to spread outward.

### Description of Embodiments

Hereinafter, an embodiment of the present invention will be described in detail with reference to the accompanying drawings.

### [Image Forming Apparatus]

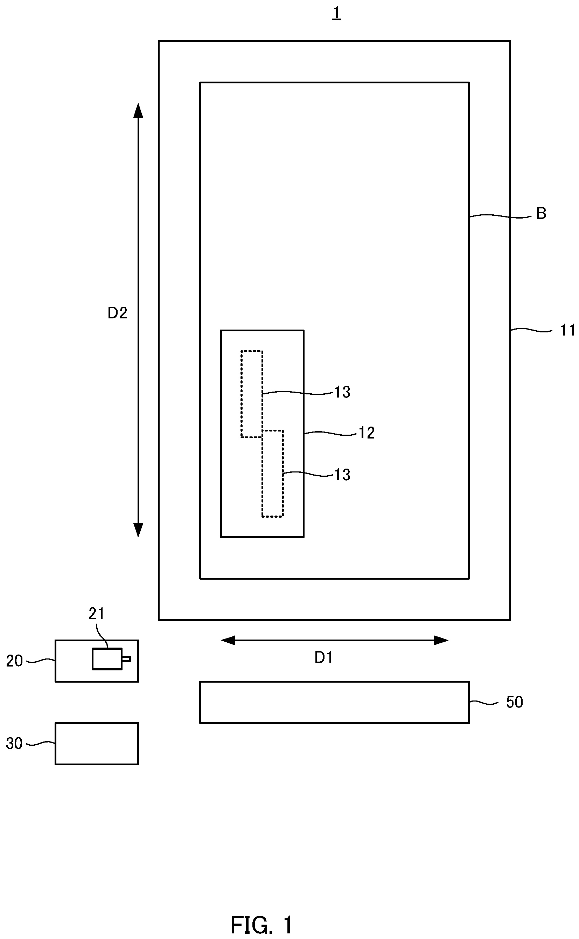

Fig. 1 is a top surface diagram illustrating the main configuration of an image forming apparatus 1 according to the present embodiment.

The image forming apparatus 1 includes: a placement base 11 on which a recording medium B is placed; a carriage 12 (the head section in the present invention) including an inkjet head (hereinafter referred to as "head") 13; a drive section 20; and a control section 30. The control section 30 is a so-called computer. Fig. 1 is a schematic diagram, and the size of each configuration is appropriately changed for convenience of description and is different from the actual size. In addition, in the following description, it is assumed that the front side of the paper surface in Fig. 1 is vertically upward, and the deep side of the paper surface in Fig. 1 is vertically downward.

The drive section 20 includes: a motor 21 that includes a rotation shaft, a coil, and an electromagnet; and a drive mechanism (not illustrated) that drives at least one of the placement base 11 and the carriage 12 by the motor 21, and is controlled by the control section 30. For example, the drive section 20 is controlled by the control section 30 based on a relative position read by a sensor which will be described later.

In the present embodiment, the drive section 20 is configured to be able to relatively move the placement base 11 and the carriage 12 in a first direction D1, and is also configured to be able to relatively move the placement base 11 and the carriage 12 in a second direction D2. The second direction is a direction orthogonal to the first direction.

For example, in a case where the position of the placement base 11 is fixed, the drive section 20 is configured to be able to move the carriage 12 independently in the first direction D1 and the second direction D2. In addition, in a case where the position of the carriage 12 is fixed, the drive section 20 may be configured to be able to move the carriage 12 independently in the first direction D1 and the second direction D2. In addition, the placement base 11 may also be configured to be movable in one of the first direction D1 and the second direction D2, and the carriage 12 may also be configured to be movable in the other one of the first direction D1 and the second direction D2. In addition, the placement base 11 may also be configured to be movable in both the first direction D1 and the second direction D2, and the carriage 12 may also be configured to be movable in both the first direction D1 and the second direction D2.

The recording medium B is an image formation target of the image forming apparatus 1, and is, for example, a board used for a printed circuit board (PCB). The printed circuit board includes: an insulating board; and a wiring conductor disposed on the insulating board.

As such a recording medium B, for example, paper phenol, paper epoxy, glass cloth epoxy, glass polyimide, glass cloth/non-woven cloth epoxy, glass cloth/paper epoxy, synthetic fiber epoxy, and the like are preferable. In addition, as such a recording medium B, a copper-clad laminate, a polyimide film, a PET film, a glass board, a ceramic board, a wafer plate, a stainless steel plate, and the like are also preferable.

The carriage 12 includes: at least one head 13; a tank (not illustrated) that stores ink and supplies the ink to the head 13; and the like. In addition, the carriage 12 includes a sensor (not illustrated) that reads a relative position with respect to the recording medium B. The operation of the head 13, the tank, and the like is controlled by the control section 30. Note that, the carriage 12 may be configured to include a head control section that operates under the control of the control section 30 and controls the operation of the head 13, the tank, and the like.

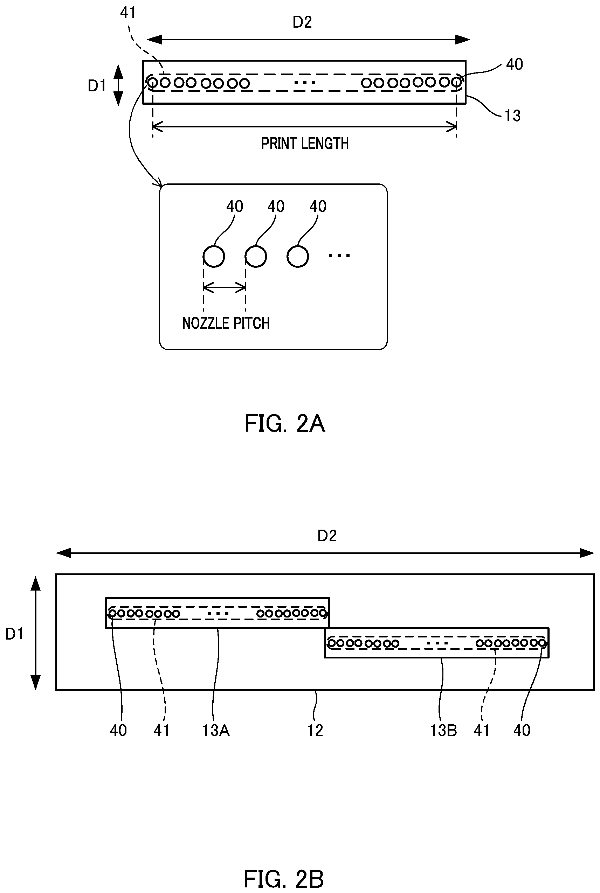

The carriage 12 having such a configuration is disposed on a side above (the front side of the paper surface of Fig. 1) the placement base 11 and the recording medium B such that nozzles 40 (see Figs. 2A and 2B to be described later) of the head 13 face the recording medium B.

Fig. 2A is a diagram illustrating an example of the configuration of the head 13. In addition, Fig. 2B is a diagram illustrating an example of the configuration of the carriage 12 including the head 13 illustrated in Fig. 2A. In Fig. 2B, for convenience of the following description, two heads 13 are denoted by reference signs 13A and 13B. In addition, Fig. 2A is a diagram of the head 13 viewed from the lower side, that is, the side of the placement base 11 (recording medium B), and Fig. 2B is a diagram of the carriage 12 viewed from the lower side, that is, the side of the placement base 11 (recording medium B).

As illustrated in Fig. 2A, the head 13 includes a plurality of nozzles 40 that discharges ink (ink droplets). In Fig. 2A, the plurality of nozzles 40 is arranged in a row at each nozzle pitch along the second direction D2 to form one nozzle column 41.

As illustrated in Fig. 2B, the carriage 12 includes the two heads 13A and 13B. The heads 13Aand 13B are arranged to be shifted from each other in the first direction D1 and are disposed so as to extend in the second direction D2. In each of the heads 13A and 13B, the plurality of nozzles 40 (the nozzle column 41) is arranged along the second direction D2. With such an arrangement, the print length of one carriage 12 can be increased.

In addition, the carriage 12 may be configured such that an end portion of the nozzle column 41 of the head 13A includes an image formation region overlapping with the nozzle column 41 of the head 13B adjacent to the head 13A. Thus, it is possible to cause the joints between the heads 13A and 13B and between passes to be described later to overlap with each other, to prevent gaps, streaks, and the like, and to make the joints inconspicuous.

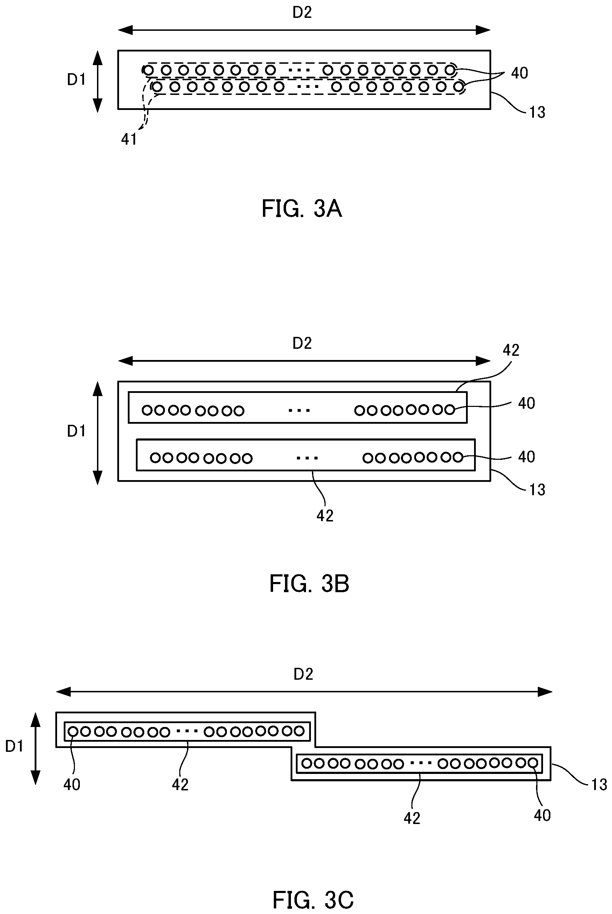

Note that, the heads 13, 13A, and 13B illustrated in Figs. 2A and 2B are configured to include one nozzle column 41, but the head 13 may also be configured to include, for example, a plurality of nozzle columns 41. Fig. 3A is a diagram illustrating another example of the configuration of the head 13. For example, as illustrated in Fig. 3A, one head 13 may include two nozzle columns 41. The example illustrated in Fig. 3A is configured such that the two nozzle columns 41 are arranged to be shifted from each other in the first direction D1 and the second direction D2 to achieve improved print resolution.

Figs. 3B and 3C are also diagrams illustrating other examples of the configuration of the head 13. It may be configured such that a head chip module 42 obtained by configuring a plurality of nozzles or a plurality of ink discharge mechanisms as a chip module is used and one head 13 includes two head chip modules 42 (two nozzle columns) as illustrated in Figs. 3B and 3C.

The example illustrated in Fig. 3B is configured such that the two head chip modules 42 are arranged to be shifted from each other in the first direction D1 and the second direction D2 to achieve improved print resolution. The example illustrated in Fig. 3C is configured such that the two head chip modules 42 are arranged to be shifted from each other in the first direction D1 and are disposed to extend in the second direction D2 to increase the print length of one head 13.

In the present embodiment, the ink is preferably a single type of ink. In a case where pixel columns are formed in the same region using a plurality of types of ink, a plurality of heads filled with various types of ink is used in a first operation to be described later. In that case, a positional deviation of a pixel column may occur by being affected by variations in the print length for each head. For this reason, it is preferable that single ink be used in a region in which pixel columns are formed in at least one first operation.

In addition, in the present embodiment, the ink is preferably, for example, ink containing a coating agent, an insulating material, or the like for manufacturing printed wiring, solder resist ink for forming a circuit in a board for a PCB, or the like. As such ink, it is possible to use ink which is cured by irradiation of energy rays, such as UV curable ink which is cured by irradiation of ultraviolet rays; thermosetting ink which has a thermosetting property and is cured by heating, or the like, in order to prevent liquid gathering of ink droplets. The UV curable ink, the thermosetting ink, and the like may include a gelling agent. Such ink is stored in the tank of the carriage 12, is supplied to the nozzles 40 of the head 13, and is discharged.

In a case where a UV curable ink, a thermosetting ink, or the like is used as the ink, the image forming apparatus 1 may include an irradiation section 50 that irradiates the recording medium B with energy rays such as ultraviolet rays or infrared rays (heat rays), as illustrated in Fig. 1. After the image formation on the recording medium B, for example, movement of the placement base 11 or the irradiation section 50 in the second direction D2 causes the image formed on the recording medium B to be irradiated with energy rays to cure the image (ink).

The image forming apparatus 1 has the above-described configuration, and forms an image on the recording medium B by the control section 30 controlling the above-described configuration. Specifically, the control section 30 uses a first operation, in which the ink is discharged from the head 13 while relatively moving the recording medium B and the carriage 12 on the placement base 11 in the first direction D1, and a second operation, in which the recording medium B and the carriage 12 are relatively moved in the second direction D2. Then, the control section 30 causes the first operation and the second operation to be repeatedly performed to form an image with the ink in a nozzle pitch corresponding region of the recording medium B, where the nozzle pitch corresponding region corresponds to a nozzle pitch (see Fig. 2A).

Note that, the image forming method to be described below will be described on the assumption that, as an example, the drive section 20 moves the placement base 11 (the recording medium B) in the first direction D1 and moves the carriage 12 (the heads 13A and 13B to be described later) in the second direction D2.

### [Image Forming Method in the Related Art - Block Printing + Feathering]

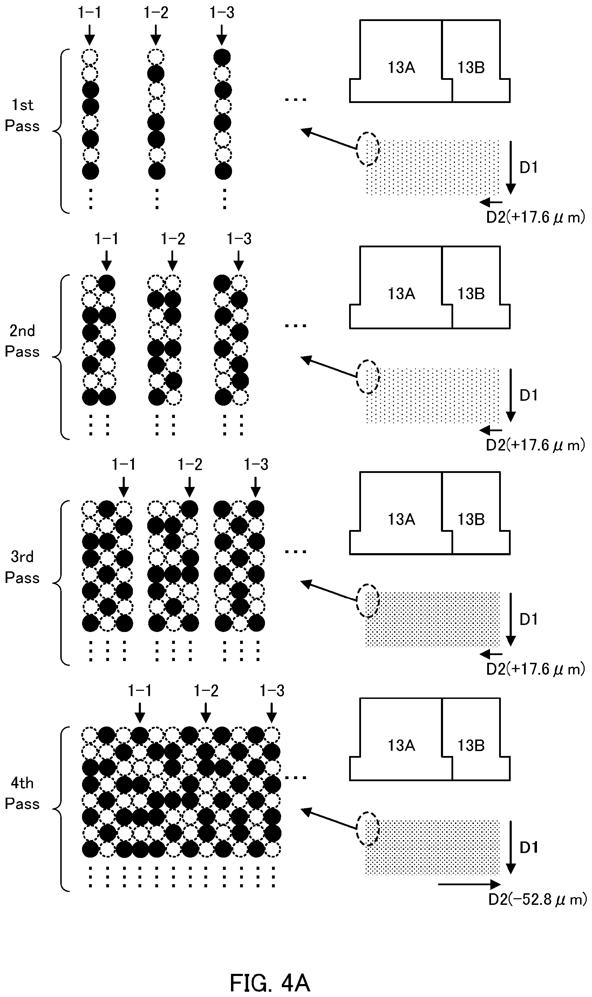

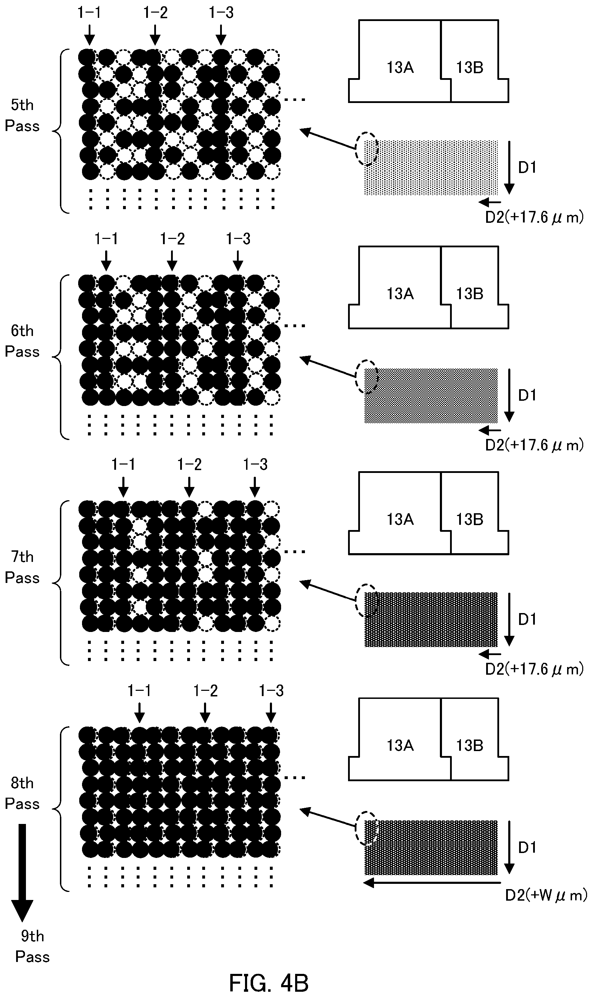

Fig. 4A is a diagram provided for describing an image forming method in the related art, which describes first to fourth passes. Fig. 4B is a diagram provided for describing the image forming method in the related art, which describes fifth to eighth passes. Here, a method in which block printing and feathering are combined will be described.

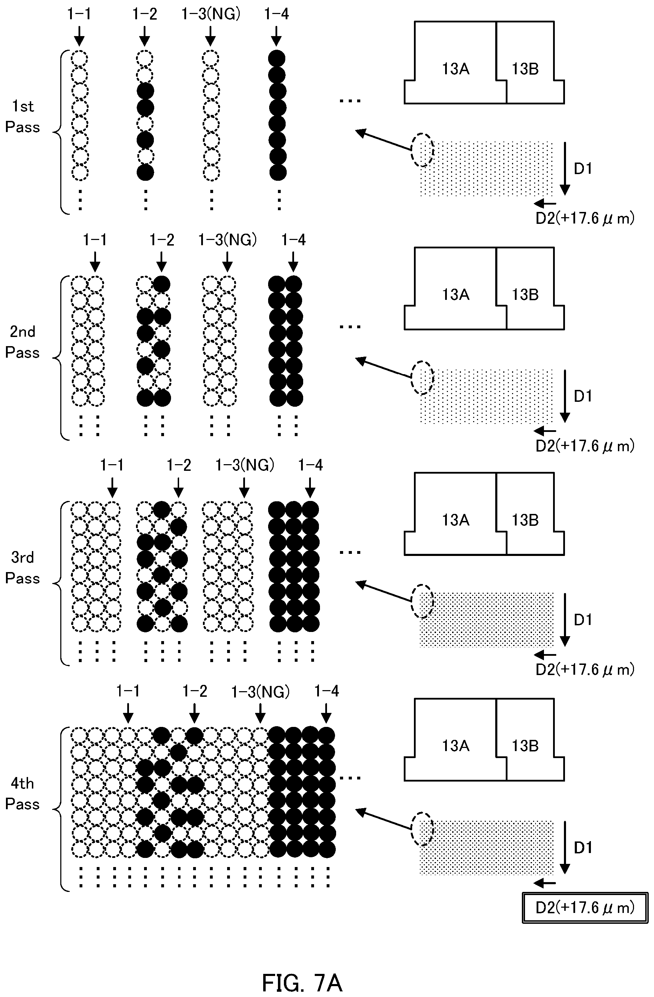

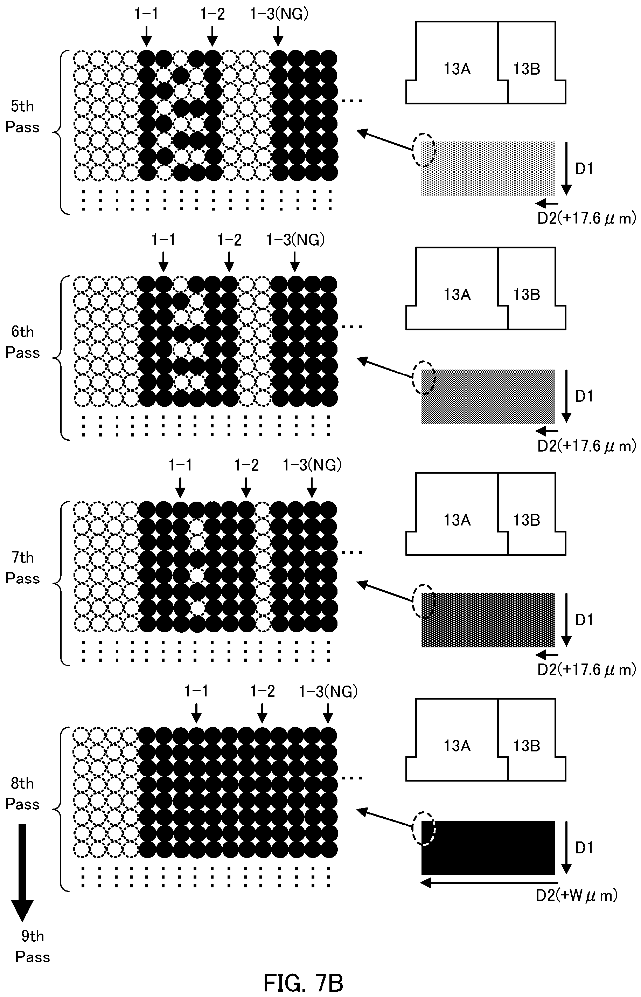

Here, the block printing is described in, for example, WO 2022/190367 (in particular, Fig. 7 and the description thereof) which is a prior application by the present inventor et al, and will be briefly described as follows. In the block printing, a nozzle pitch corresponding region on a recording medium, where the nozzle pitch corresponding region corresponding to a nozzle pitch of a head, is divided into a plurality of pixel column formation regions that form pixel columns. Then, pixel columns are formed in the pixel column formation region, and pixel columns are formed by the same nozzle of the same head in a pixel column formation region adjacent to the formed pixel column, thereby forming an image so as to fill the nozzle pitch corresponding regions. By forming an image in such a manner, a region of an image formed with one head is composed of pixels formed with the head, and pixels formed with another head are not mixed. For this reason, in an image region formed by a plurality of heads, respectively, it is possible to suppress a positional deviation due to the difference in the respective print lengths of the plurality of heads.

In addition, the feathering is a method of using random patterns that complement each other when forming pixel columns by performing the first operation a plurality of times on one pixel column formation region. The interleaving is a method of using regular patterns that complement each other when forming pixel columns by performing the first operation a plurality of times on one pixel column formation region. Since the feathering and the interleaving are different only in whether the patterns to be used are random or regular, the feathering will be described below as an example.

In addition, the right sides of Figs. 4A and 4B illustrate schematic diagrams in which relative movements of the two heads 13A and 13B and the recording medium B (formed image region) are illustrated in time series. In addition, the left sides of Figs. 4A and 4B illustrate diagrams in which the regions surrounded by the broken lines in the image regions illustrated on the right sides thereof are enlarged. In addition, in Figs. 4A and 4B, the reference sign "1-1" indicates the first nozzle 40 of the first head 13A, the reference sign "1-2" indicates the second nozzle 40 of the first head 13A, and the reference sign "1-3" indicates the third nozzle 40 of the first head 13A. In addition, it is assumed that the number of nozzles in each of the heads 13A and 13B is p.

In addition, a case where an image is formed using the carriage 12 illustrated in Fig. 2B will be described here. Specifically, a case in which an image with a print resolution of 1440 dpi is formed by performing four-pass block printing using the heads 13A and 13B with a nozzle density of 360 dpi (dots per inch) will be described.

Note that, in the following description, the number of passes is the number of pixel column formation regions obtained by dividing a nozzle pitch corresponding region in the second direction. In addition, the first pass means the first operation from the start of printing, and the same applies to the second and subsequent passes.

First, the control section 30 causes the first operation of the first pass to be performed. For example, the control section 30 uses the nozzles 40 of the heads 13A and 13B to discharge ink while moving the heads 13A and 13B along the first direction D1 in a state in which the recording medium B is stationary, thereby forming pixel columns in the pixel column formation region of the first pass. At this time, the control section 30 causes the pixel columns to be formed without discharge of the ink to part of the pixel column formation region of the first pass.

Thus, pixel columns for 2 × p columns spaced apart by an interval corresponding to the nozzle pitch are formed on the recording medium B. In each pixel column, not all pixels but some pixels are formed. When p = 1024, that is, when the number of nozzles of each of the heads 13A and 13B is 1024, an image region is formed by pixel columns for 2 × 1024 = 2048 columns.

After the pixel columns in the first pass are formed, the control section 30 causes the second operation to be performed, and, for example, causes the recording medium B to be moved by a predetermined amount along the second direction D2. Here, since the four-pass block printing is performed, the predetermined amount is a distance obtained by dividing the distance between the nozzle pitches into quarters. For example, when it is assumed that the print length of each of the heads 13A and 13B is 72.1 mm and the number of nozzles thereof is 1024, the distance between the nozzle pitches is 70.4 µm and the predetermined amount is 17.6 µm. This predetermined amount corresponds to the width for one pixel in the second direction D2.

Next, the control section 30 causes the first operation and the second operation in the second and third passes to be performed sequentially, where the first operation and the second operation in the second and third passes are the same as the first operation and the second operation in the first pass. Thus, on the recording medium B, pixel columns in the second pass are formed adjacent to the pixel columns formed in the first pass, and pixel columns in the third pass are formed adjacent to the pixel columns formed in the second pass.

Next, the control section 30 causes the first operation in the fourth pass to be performed. The first operation in the fourth pass is basically the same as the first operations in the first to third passes. By the first operation in the fourth pass, the image formation of pixel columns between the nozzle pitches is completed. That is, by performing the first operation and the second operation in the first to fourth passes, four adjacent pixel columns are formed by the same nozzle 40.

After the pixel columns in the fourth pass are formed, the control section 30 causes the second operation to be performed and causes, for example, the recording medium B to move along the second direction D2, but the movement direction in the second direction D2 is opposite to that in the first to third passes since the image formation is performed on the same pixel column formation region with the same nozzle. The movement amount this time is 52.8 µm because the total of the movements in the first to third passes is 52.8 µm. In the fourth pass, the movement direction in the second direction D2 is opposite to the movement direction in the first to third passes, and the movement amount is described as -52.8 µm in Fig. 4A.

Next, the control section 30 causes the first operation and the second operation in the fifth to eighth passes to be performed sequentially. The first operation and the second operation in the fifth to eighth passes are basically the same as the first operation and the second operation in the first to fourth passes.

At this time, as can be seen from Figs. 4A and 4B, it is configured such that the image formation is performed on the same pixel column formation region with the same nozzle. Specifically, in the fifth pass, the ink is discharged to part of the pixel column formation region, in which no pixels have been formed in the first pass. Thus, pixels in the fifth pass are formed in the part of the pixel column formation region, in which no pixels have been formed, in the pixel columns in the first pass, thereby completing the pixel columns.

The sixth to eighth passes are the same as the fifth pass, and the ink is discharged to the part of the pixel column formation region, in which no pixels have been formed in the second to fourth passes in each of the sixth to eighth passes. Thus, the pixels in each of the sixth to eighth passes are formed in the part of the pixel column formation region, in which no pixels have been formed, in the pixel columns in each of the second to fourth passes, thereby completing the pixel columns. By performing the first operation and the second operation in the fifth to eighth passes, four adjacent pixel columns are formed by the same nozzle 40, and the image formation of pixel columns between the nozzle pitches is completed.

By performing the first operation and the second operation in the first to eighth passes as described above, an image region is formed in a predetermined region as illustrated in the eighth pass of Fig. 4B.

In a case where the pixel columns in the next ninth pass and subsequent passes are formed after the formation of the pixel columns in the eighth pass, the control section 30 causes, for example, the recording medium B to move. For example, in a case where the next image region is formed in a region adjacent to the image region formed in the first to eighth passes in the second direction D2, the control section 30 causes the recording medium B to move by a predetermined amount along the second direction D2. The predetermined amount W here is the print lengths for the two heads 13A and 13B ± the distance between the nozzle pitches, and the predetermined amount W is changed depending on which side of the image region formed in the first to eighth passes the next image region is adjacent in the second direction D2.

Note that, when the movement is performed from the position of the pixel columns in the eighth pass to the position at which the pixel columns in the next ninth pass are formed, the predetermined amount W may be a movement amount which is smaller than the print lengths ± the distance between the nozzle pitches. Thus, the joint between the pixel columns in the eighth pass and the pixel columns in the ninth pass can be overlapped to reduce the influence of the joint.

By repeatedly performing the above-described operations, a desired image, for example, a wiring pattern or the like is formed on the recording medium B.

By the operations described above, four adjacent pixel columns are formed in two stages by the same nozzle 40. For this reason, even in a case where the print length is different between the heads 13A and 13B, or even in a case where the landing position is different due to the ink ejection angle of the nozzle 40, it is possible to minimize the influence thereof, and it is possible to prevent gaps, streaks, and the like from occurring between the pixel columns adjacent to each other.

However, in the first to eighth passes described above, the movement direction in the second direction D2 in the fourth pass is opposite to that in the first to third passes. In addition, in some cases, even in the eighth pass, the movement direction in the second direction D2 may be opposite to those in the first to third passes and the fifth to seventh passes. As described above, when the movement direction is reversed, movement accuracy at the time of reversal may deteriorate due to a structural play (also referred to as backlash) of the movement mechanism of the drive section 20. In this case, as illustrated in Fig. 4B, the ink is discharged while being deviated from target ejection positions (see the dotted lines) (see the black circles deviated from the dotted lines), which may cause defects such as gaps or streaks.

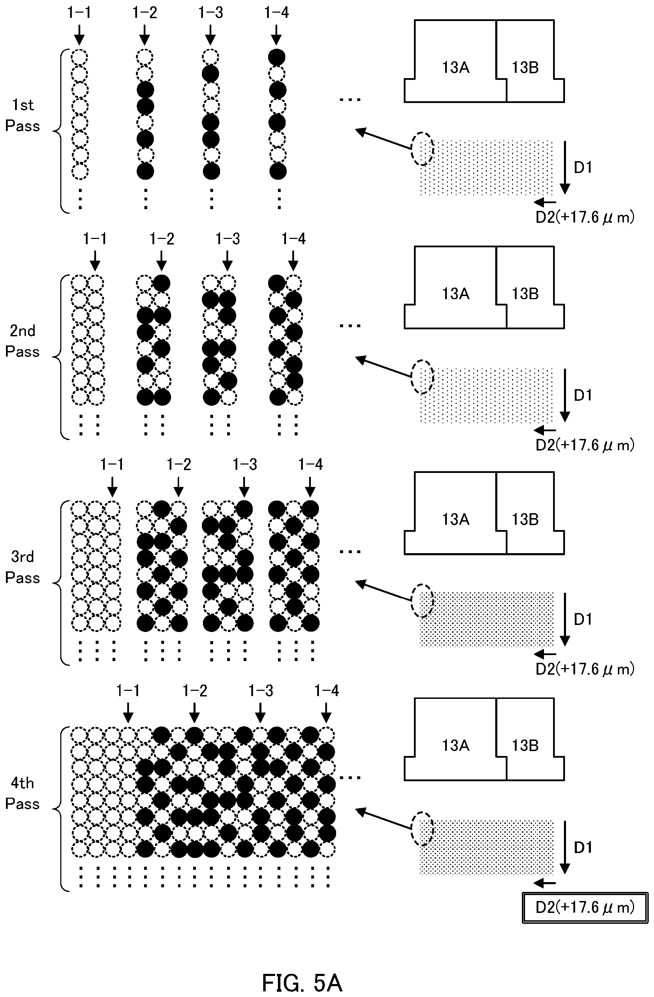

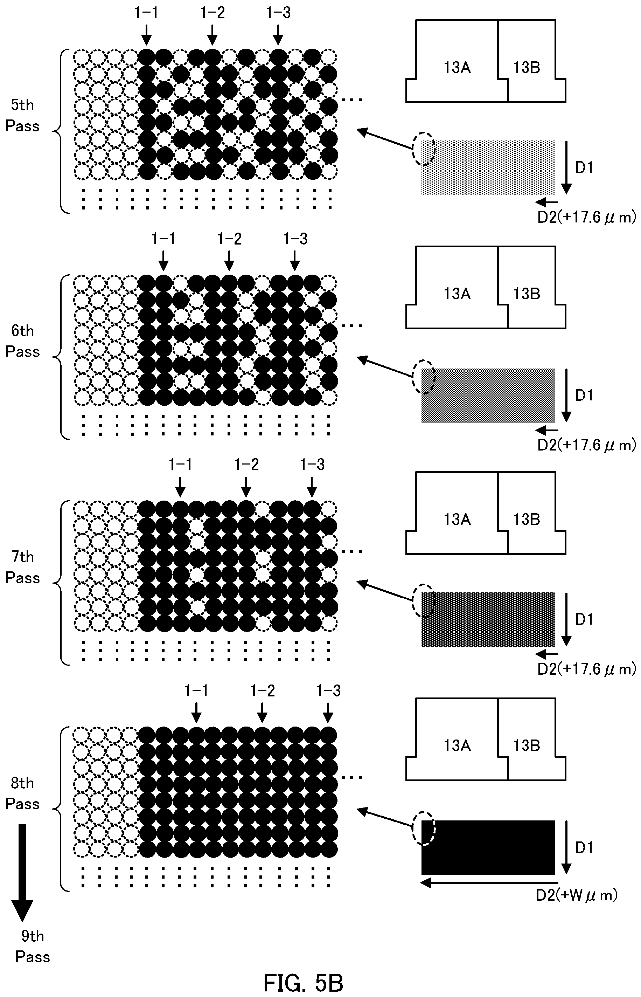

Accordingly, it is configured in the present embodiment such that by performing the image forming method illustrated in Figs. 5A and 5B, movement in only one direction is performed in the second direction D2, deterioration in the movement accuracy is prevented, and defects such as gaps and streaks are prevented from occurring.

### [Image Forming Method of the Present Embodiment - Block Printing + Feathering]

Fig. 5A is a diagram provided for describing an image forming method according to the present embodiment, which describes the first to fourth passes. Fig. 5B is a diagram provided for describing the image forming method according to the present embodiment, which describes the fifth to eighth passes. Here, a method in which the block printing and the feathering are combined will also be described.

In addition, in Figs. 5A and 5B, the figures illustrated on the left and right are the same as those in Figs. 4A and 4B, and the reference sign "1-1" and the like are also as described in Figs. 4A and 4B. In addition, it is assumed that the number of nozzles in each of the heads 13A and 13B is also p.

In addition, a case in which an image with a print resolution of 1440 dpi is formed by performing four-pass block printing using the carriage 12 illustrated in Fig. 2B, specifically, using the heads 13A and 13B with a nozzle density of 360 dpi, will also be described here.

Accordingly, in the present embodiment, the number of divisions of a nozzle pitch corresponding region of the recording medium B in the second direction, where the nozzle pitch corresponding region corresponds to the nozzle pitch (see Fig. 2A), is m = 4. In other words, the number of pixel column formation regions (pixel columns) in a nozzle pitch corresponding region is m = 4. Then, it is configured in the present embodiment such that the first operation is performed n = 2 times by n = 2 nozzles 40 with respect to each of m = 4 pixel column formation regions obtained by dividing the region in the second direction into m = 4 pixel column formation regions.

First, the control section 30 causes the first operation of the first pass to be performed. For example, the control section 30 uses the nozzles 40 of the heads 13A and 13B to discharge ink while moving the heads 13A and 13B along the first direction D1 in a state in which the recording medium B is stationary, thereby forming pixel columns in the pixel column formation region of the first pass. At this time, the control section 30 causes the pixel columns to be formed without discharge of the ink to part of the pixel column formation region of the first pass. Further, in the present embodiment, the discharge of ink is prohibited in the nozzle 1-1, which is the nozzle 40 at one end portion, and no pixel column formation is performed.

Thus, pixel columns for 2 × p-1 columns spaced apart by an interval corresponding to the nozzle pitch are formed on the recording medium B except for the pixel column formation region corresponding to the nozzle 1-1. In each pixel column, not all pixels but some pixels are formed. When p = 1024, that is, when the number of nozzles of each of the heads 13A and 13B is 1024, an image region is formed by pixel columns for 2 × 1024-1 = 2047 columns.

After the pixel columns in the first pass are formed, the control section 30 causes the second operation to be performed, and, for example, causes the recording medium B to be moved by a predetermined amount along the second direction D2. Even here, since the four-pass block printing is performed, the predetermined amount is a distance obtained by dividing the distance between the nozzle pitches into quarters, for example, is 17.6 µm.

Next, the control section 30 causes the first operation and the second operation in the second and third passes to be performed sequentially, where the first operation and the second operation in the second and third passes are the same as the first operation and the second operation in the first pass. Thus, on the recording medium B, except for the pixel column formation region corresponding to the nozzle 1-1, pixel columns in the second pass are formed adjacent to the pixel columns formed in the first pass, and pixel columns in the third pass are formed adjacent to the pixel columns formed in the second pass.

Next, the control section 30 causes the first operation and the second operation in the fourth pass to be performed. In the present embodiment, the first operation and the second operation in the fourth pass are the same as the first operation and the second operation in the first to third passes. After the pixel columns in the fourth pass are formed, the control section 30 causes the second operation to be performed and causes the recording medium B to move by the predetermined amount in the second direction D2 which is the same direction as that in the first to third passes. Then, by the first operation in the fourth pass, the image formation of pixel columns between the nozzle pitches is completed except for the pixel column formation region corresponding to the nozzle 1-1.

Next, the control section 30 causes the first operation and the second operation in the fifth to eighth passes to be performed sequentially. The first operation and the second operation in the fifth to eighth passes are basically the same as the first operation and the second operation in the first to fourth passes, but it is configured such that the nozzle 1-1 also discharges the ink and the pixels of pixel columns are formed in the same pixel column formation region by different adjacent nozzles 40.

For example, as can be seen from the comparison between the first pass and the fifth pass, the ink is discharged in the fifth pass from the nozzle 1-1 to part of the pixel column formation region, in which no pixels have been formed, in the pixel columns formed by the nozzle 1-2 in the first pass, to form pixels. The same applies to the other pixel columns, for example, the ink is discharged in the fifth pass from the nozzle 1-2 to part of the pixel column formation region, in which no pixels have been formed, in the pixel columns formed by the nozzle 1-3 in the first pass, to form pixels. Thus, pixels in the fifth pass are formed in the part of the pixel column formation region, in which no pixels have been formed, in the pixel columns in the first pass, thereby completing the pixel columns.

The sixth to eighth passes are the same as the fifth pass. That is, the ink is discharged in the sixth to eighth passes from a nozzle adjacent to and different from the nozzle in the second to fourth passes to part of the pixel column formation region, in which no pixels have been formed, in the pixel columns formed in the second to fourth passes, to form pixels. Thus, the pixels in each of the sixth to eighth passes are formed in the part of the pixel column formation region, in which no pixels have been formed, in the pixel columns in each of the second to fourth passes, thereby completing the pixel columns.

Note that, in the last four passes (the fifth to eighth passes), the discharge of ink in the nozzle 40 (in a case where p = 1024, the nozzle 2-1024) at the end portion on the opposite side to the side on which the nozzle 1-1 described above is disposed may be prohibited and no pixel column formation may be performed.

By performing the first operation and the second operation in the first to eighth passes described above, an image region is formed in a predetermined region as illustrated in the eighth pass of Fig. 5B.

In a case where the pixel columns in the next ninth pass and subsequent passes are formed after the formation of the pixel columns in the eighth pass, the control section 30 causes the recording medium B to move. Even here, the control section 30 causes the recording medium B to move in the second direction D2 which is the same direction as that in the first to seventh passes.

At this time, processing may be performed in which the movement amount in the second direction D2 is set to a movement amount smaller than the print lengths ± the distance between the nozzle pitches and the joint between the eighth and ninth passes is overlapped to reduce the influence of the joint.

By repeatedly performing the above-described operations, a desired image, for example, a wiring pattern or the like is formed on the recording medium B.

By the operations described above, four adjacent pixel columns are formed in two stages by two adjacent nozzles 40. For this reason, even in a case where the print length is different between the heads 13A and 13B, it is possible to suppress the influence thereof, and it is possible to prevent gaps, streaks, and the like from occurring between the pixel columns adjacent to each other.

In addition, in the present embodiment, in the case of the movement in the second direction D2, the control section 30 causes the movement to occur in the same direction in all of the passes, and thus, there is no reversal of the movement direction. For this reason, there is no deterioration in the movement accuracy due to a structural play (backlash) of the movement mechanism of the drive section 20, and it is possible to prevent deterioration in the movement accuracy. In particular, in a case where the motor 21 is used as the drive source of the drive section 20, it is possible to prevent deterioration in the movement accuracy by configuring no reversal of the movement direction and configuring the movement to be only in one direction. As a result, it is possible to prevent a gap, a streak, or the like from occurring between the pixel columns adjacent to each other.

### [Summary]

As described above, the image forming apparatus 1 in the present embodiment includes: the carriage 12; and the control section 30 that causes the first operation and the second operation to be performed.

In a case where the first operation is performed n times, where n is an integer equal to or greater than 2, with respect to each of m pixel column formation regions, where m is an integer equal to or greater than 1, obtained by dividing a nozzle pitch corresponding region of the recording medium B into the m pixel column formation regions in the second direction D2, where the nozzle pitch corresponding region corresponds to a nozzle pitch, the control section 30 performs as follows. Specifically, the control section 30 prohibits the discharge of ink in at least one of the nozzles 40 from the side of an end portion of the carriage 12 in at least one of a plurality of the first operations when the second operation in which the recording medium B and the carriage 12 are moved in one direction to one side in the second direction D2 is performed m × n times.

In the example illustrated in Figs. 5A and 5B, m = 4 and n = 2. Accordingly, the first operation and the second operation are performed eight (m × n = 8) times. In a case where the first operation is performed twice (n = 2) by two (n = 2) nozzles 40 with respect to each of four (m = 4) pixel column formation regions obtained by dividing a nozzle pitch corresponding region into four (m = 4) pixel column formation regions in the second direction D2, the control section 30 performs as follows. Specifically, the control section 30 prohibits, in each of the first four (m = 4) first operations among the plurality of the first operations, the discharge of the ink in one (n-1 = 1) nozzle 1-1 from an end portion of the carriage 12 on the other side in the second direction D2 when the second operation in which the recording medium B and the carriage 12 are moved in the one direction to the one side in the second direction D2 is performed eight times. Note that, the control section 30 may prohibit, in each of the last four (m = 4) first operations among the plurality of the first operations, the discharge of the ink in one (n-1 = 1) nozzle 40 (in a case where p = 1024, the nozzle 2-1024) from an end portion of the carriage 12 on the one side in the second direction D2. This also applies to Variations 1 to 4 to be described later.

The present embodiment is also applicable to, for example, a case where n = 3, that is, a case where the first operation is performed three times on the same pixel column formation region of the recording medium B by different nozzles 40. In this case, when m = 4, first operation and the second operation is performed twelve (m × n = 12) times. The control section 30 may prohibit, in each of the first four (m = 4) first operations among the plurality of the first operations, the discharge of the ink in two (n-1 = 2) nozzles 1-1 and 1-2 from the end portion of the carriage 12 on the other side in the second direction D2 when the second operation in which the recording medium B and the carriage 12 are moved in the one direction to the one side in the second direction D2 is performed twelve times. As described above, in the present embodiment, n is changeable, and m is also changeable as illustrated in Variation 2 to be described later.

According to the image forming apparatus 1 in the present embodiment configured as described above, in the case of the movement in the second direction D2, the movement is caused to occur in the same direction in all of the passes, and thus, there is no reversal of the movement direction. For this reason, there is no deterioration in the movement accuracy due to a structural play (backlash) of the movement mechanism of the drive section 20, and it is possible to prevent deterioration in the movement accuracy. As a result, it is possible to prevent a gap, a streak, or the like from occurring between the pixel columns adjacent to each other.

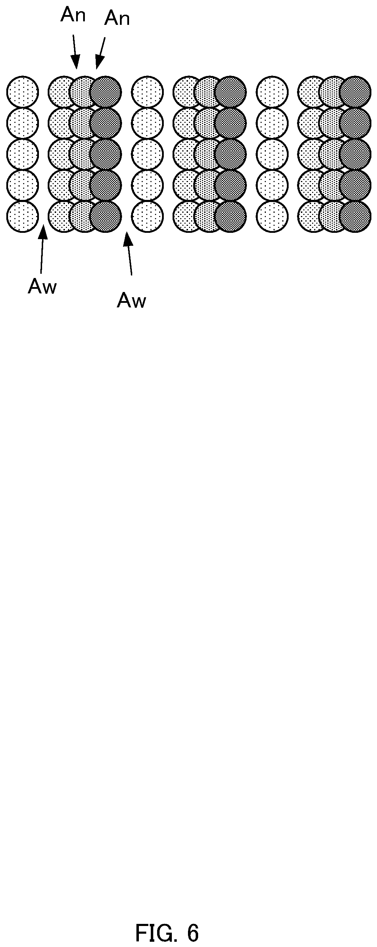

In general multi-pass printing, when there are variations in the print length for each head, the position of the nozzle with respect to the recording medium deviates from the original position thereof for each head. For this reason, in a case where adjacent pixel columns are formed by different heads, portions Aw where the interval between pixel columns becomes wide and portions An where the interval between pixel columns becomes narrow conversely may occur as illustrated in Fig. 6. Here, Fig. 6 is a diagram provided for describing a state in which the intervals between pixel columns are not uniform in a case where there are variations in the print length for each head in general multi-pass printing. Fig. 6 illustrates positional deviations of pixel columns in an exaggerated manner. In a case where an image forming apparatus is used to print a wiring portion of a PCB, or the like (for example, solder resist ink for forming a circuit of a board for a PCB), such positional deviations of pixel columns may become a serious defect.

On the other hand, in the present embodiment, the image forming method described above makes it possible to suppress a positional deviation of a pixel column even in a case where the print lengths of the plurality of heads 13 are different from each other, for example, in an application such as printing solder resist ink for forming a circuit of a board for a PCB. For this reason, it is possible to prevent a defect caused due to a positional deviation of a pixel column at the time of forming a circuit of a PCB board.

### <Variation 1>

Fig. 7A is a diagram provided for describing a variation of the image forming method according to the present embodiment, which describes the first to fourth passes. Fig. 7B is a diagram provided for describing the variation of the image forming method according to the present embodiment, which describes the fifth to eight passes. Here, a method in which the block printing and the feathering are combined will also be described.

In addition, in Figs. 7A and 7B, the figures illustrated on the left and right are the same as those in Figs. 4A and 4B, and the reference sign "1-1" and the like are also as described in Figs. 4A and 4B. In addition, it is assumed that the number of nozzles in each of the heads 13A and 13B is also p. In the present variation, however, it is assumed as an example that the nozzle 1-3 is in an unusable state due to non-discharge, discharge bending, or the like. It is configured such that the state (usable or unusable) of the nozzle 40 is checked in advance using, for example, an inspection apparatus that inspects the heads 13A and 13B, an inspection apparatus that reads an image formed by the heads 13A and 13B and inspects the image, or the like.

In addition, a case in which an image with a print resolution of 1440 dpi is formed by performing four-pass block printing using the carriage 12 illustrated in Fig. 2B, specifically, using the heads 13A and 13B with a nozzle density of 360 dpi, will also be described here.

First, the control section 30 causes the first operation of the first pass to be performed. For example, the control section 30 uses the nozzles 40 of the heads 13A and 13B to discharge ink while moving the heads 13A and 13B along the first direction D1 in a state in which the recording medium B is stationary, thereby forming pixel columns in the pixel column formation region of the first pass. At this time, the control section 30 causes the pixel columns to be formed without discharge of the ink to part of the pixel column formation region of the first pass. Further, in the present embodiment, the discharge of ink is prohibited in the nozzle 1-1, which is the nozzle 40 at one end portion, no pixel column formation is performed, and no pixel column formation is performed in the nozzle 1-3, either. In addition, since the position of pixel columns formed by the nozzle 1-4 is that to which the nozzle 1-3 moves in the fifth pass, the ink is discharged to all pixels of the pixel columns.

Thus, 2 × p-2 pixel columns are formed on the recording medium B except for the pixel column formation regions corresponding to the nozzles 1-1 and 1-3. All pixels are formed in one pixel column of the 2 × p-2 pixel columns, whereas not all pixels but some pixels are formed in 2 × p-3 pixel columns.

After the pixel columns in the first pass are formed, the control section 30 causes the second operation to be performed, and, for example, causes the recording medium B to be moved by a predetermined amount along the second direction D2. Even here, since the four-pass block printing is performed, the predetermined amount is a distance obtained by dividing the distance between the nozzle pitches into quarters, for example, is 17.6 µm.

Next, the control section 30 causes the first operation and the second operation in the second and third passes to be performed sequentially, where the first operation and the second operation in the second and third passes are the same as the first operation and the second operation in the first pass. Thus, on the recording medium B, except for the pixel column formation regions corresponding to the nozzles 1-1 and 1-3, pixel columns in the second pass are formed adjacent to the pixel columns formed in the first pass, and pixel columns in the third pass are formed adjacent to the pixel columns formed in the second pass.

Next, the control section 30 causes the first operation and the second operation in the fourth pass to be performed. The first operation and the second operation in the fourth pass are the same as the first operation and the second operation in the first to third passes also in the present variation as well. After the pixel columns in the fourth pass are formed, the control section 30 causes the second operation to be performed and causes the recording medium B to move by the predetermined amount in the second direction D2 which is the same direction as that in the first to third passes. Then, by the first operation in the fourth pass, the image formation of pixel columns between the nozzle pitches is completed except for the pixel column formation regions corresponding to the nozzles 1-1 and 1-3.

Next, the control section 30 causes the first operation and the second operation in the fifth to eighth passes to be performed sequentially. The first operation and the second operation in the fifth to eighth passes are basically the same as the first operation and the second operation in the first to fourth passes, but it is configured such that the nozzle 1-1 also discharges the ink and the pixels of pixel columns are formed in the same pixel column formation region by different adjacent nozzles 40.

For example, as can be seen from the comparison between the first pass and the fifth pass, the ink is discharged in the fifth pass from the nozzle 1-1 to part of the pixel column formation region, in which no pixels have been formed, in the pixel columns formed by the nozzle 1-2 in the first pass, to form pixels.

The same applies to the other pixel columns, but in the fifth pass, the following matters are performed in the nozzle 1-2 and 1-3. As can be seen from the comparison between the first pass and the fifth pass, since no pixel columns have been formed in the pixel column formation region corresponding to the nozzle 1-3 in the first pass, the ink is discharged in the fifth pass from the nozzle 1-2 to all pixels of the pixel column in the same pixel column formation region. In addition, since all pixels in the pixel columns are formed by the nozzle 1-4 in the first pass, pixel column formation by the nozzle 1-3 is not performed in the fifth pass with respect to the pixel columns formed by the nozzle 1-4 in the first pass.

Thus, pixels in the fifth pass are formed in the part of the pixel column formation region, in which no pixels have been formed, in the pixel columns in the first pass, thereby completing the pixel columns.

The sixth to eighth passes are the same as the fifth pass. That is, the ink is discharged in the sixth to eighth passes from a nozzle adjacent to and different from the nozzle in the second to fourth passes to part of the pixel column formation region, in which no pixels have been formed, in the pixel columns formed in the second to fourth passes, to form pixels. Thus, the pixels in each of the sixth to eighth passes are formed in the part of the pixel column formation region, in which no pixels have been formed, in the pixel columns in each of the second to fourth passes, thereby completing the pixel columns.

By performing the first operation and the second operation in the first to eighth passes described above, an image region is formed in a predetermined region as illustrated in the eighth pass of Fig. 7B.

In a case where the pixel columns in the next ninth pass and subsequent passes are formed after the formation of the pixel columns in the eighth pass, the control section 30 causes the recording medium B to move. Even here, the control section 30 causes the recording medium B to move in the second direction D2 which is the same direction as that in the first to seventh passes.

By repeatedly performing the above-described operations, a desired image, for example, a wiring pattern or the like is formed on the recording medium B.

By the operations described above, four adjacent pixel columns are formed in two stages by two adjacent nozzles 40 in pixel column formation regions except for the pixel column formation region corresponding to the nozzle 1-3 that is unusable. In addition, in the pixel column formation region corresponding to the nozzle 1-3 that is unusable, four adjacent pixel columns are formed by a nozzle other than the nozzle 1-3, for example, the nozzle 1-2 or 1-4 adjacent to the nozzle 1-3. For this reason, even in a case where the print length is different between the heads 13A and 13B, it is possible to suppress the influence thereof, and it is possible to prevent gaps, streaks, and the like from occurring between the pixel columns adjacent to each other.

In addition, in the present variation as well, in the case of the movement in the second direction D2, the control section 30 causes the movement to occur in the same direction in all of the passes, and thus, there is no reversal of the movement direction. For this reason, there is no deterioration in the movement accuracy due to a structural play (backlash) of the movement mechanism of the drive section 20, and it is possible to prevent deterioration in the movement accuracy. As a result, it is possible to prevent a gap, a streak, or the like from occurring between the pixel columns adjacent to each other.

In addition, even when there is an unusable nozzle 40 but when there is a nozzle 40 other than the unusable nozzle 40 is usable, the control section 30 performs control such that the ink is discharged by using the usable nozzle 40 to the nozzle pitch corresponding region of the recording medium B, where the nozzle pitch corresponding region corresponds to the unusable nozzle 40. Thus, even when there is an unusable nozzle 40, it is possible to prevent gaps, streaks, and the like from occurring between the pixel columns adjacent to each other.

### <Variation 2>

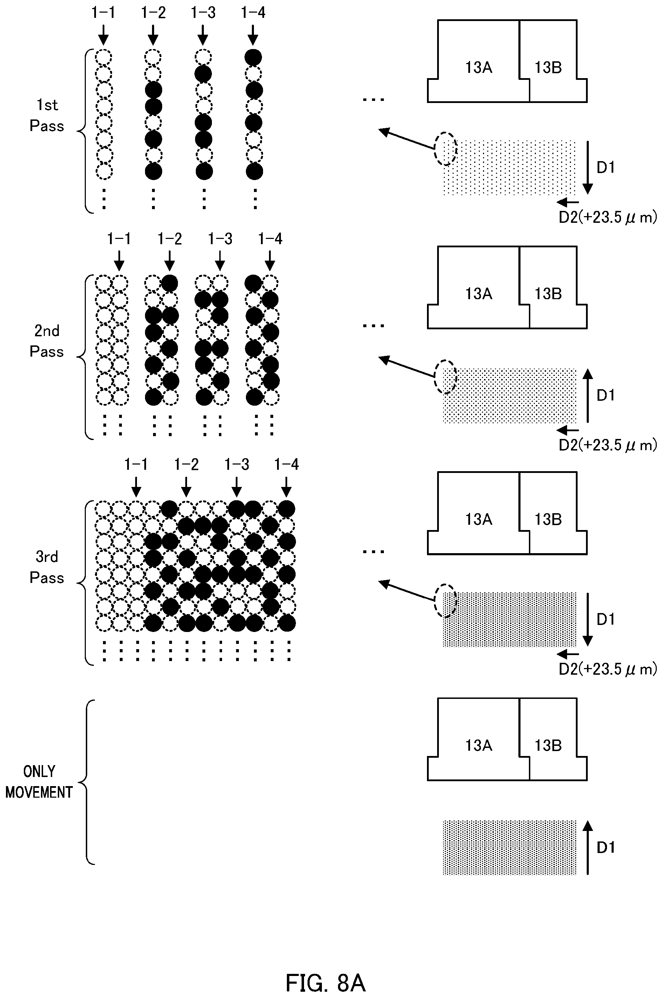

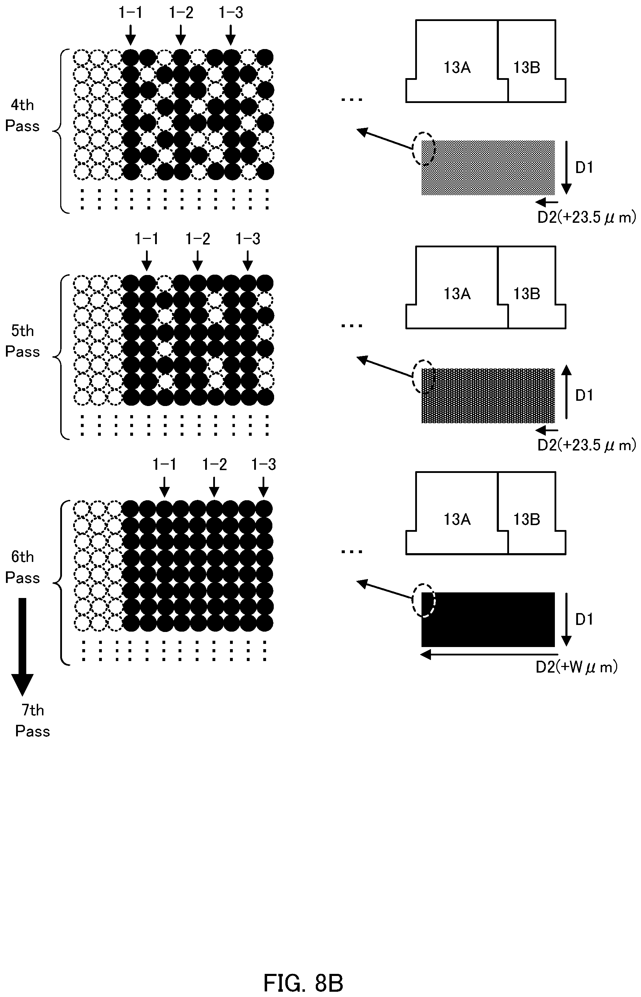

Fig. 8A is a diagram provided for describing another variation of the image forming method according to the present embodiment, which describes the first to third passes. In addition, Fig. 8B is a diagram provided for describing the other variation of the image forming method according to the present embodiment, which describes the fourth to sixth passes. Here, a method in which the block printing and the feathering are combined will also be described.

In addition, in Figs. 8A and 8B, the figures illustrated on the left and right are the same as those in Figs. 4A and 4B, and the reference sign "1-1" and the like are also as described in Figs. 4A and 4B. In addition, it is assumed that the number of nozzles in each of the heads 13A and 13B is also p.

In addition, a case in which an image with a print resolution of 1080 dpi is formed by performing three-pass block printing using the carriage 12 illustrated in Fig. 2B, specifically, using the heads 13A and 13B with a nozzle density of 360 dpi, will also be described here.

First, the control section 30 causes the first operation of the first pass to be performed. For example, the control section 30 uses the nozzles 40 of the heads 13A and 13B to discharge ink while moving the heads 13A and 13B along the first direction D1 in a state in which the recording medium B is stationary, thereby forming pixel columns in the pixel column formation region of the first pass. At this time, the control section 30 causes the pixel columns to be formed without discharge of the ink to part of the pixel column formation region of the first pass. Further, in the present variation as well, the discharge of ink is prohibited in the nozzle 1-1, which is the nozzle 40 at one end portion, and no pixel column formation is performed.

Thus, pixel columns for 2 × p-1 columns spaced apart by an interval corresponding to the nozzle pitch are formed on the recording medium B except for the pixel column formation region corresponding to the nozzle 1-1. In each pixel column, not all pixels but some pixels are formed. When p = 1024, that is, when the number of nozzles of each of the heads 13A and 13B is 1024, an image region is formed by pixel columns for 2 × 1024-1 = 2047 columns.

After the pixel columns in the first pass are formed, the control section 30 causes the second operation to be performed, and, for example, causes the recording medium B to be moved by a predetermined amount along the second direction D2. Here, since three-pass block printing is performed, the predetermined amount is a distance obtained by dividing the distance between the nozzle pitches into thirds, for example, is 23.5 µm.

Next, the control section 30 causes the first operation and the second operation in the second pass to be performed. The first operation and the second operation in the second pass are the same as the first operation and the second operation in the first pass except for the movement direction in the first direction D1. In the second pass, the movement direction in the first direction D1 is opposite to that in the first pass. Thus, on the recording medium B, except for the pixel column formation region corresponding to the nozzle 1-1, pixel columns in the second pass are formed adjacent to the pixel column formed in the first pass.

Next, the control section 30 causes the first operation and the second operation in the third pass to be performed. The first operation and the second operation in the third pass are the same as the first operation and the second operation in the first pass, including the movement direction in the first direction D1. Thus, on the recording medium B, except for the pixel column formation region corresponding to the nozzle 1-1, pixel columns in the third pass are formed adjacent to the pixel column formed in the second pass. By the first operation in the third pass, the image formation of pixel columns between the nozzle pitches is completed except for the pixel column formation region corresponding to the nozzle 1-1.

In the embodiment and Variation 1 described above, the movement directions in the first direction D1 are all the same, whereas it is configured here such that the movement directions in the first direction D1 are alternately reversed in the first to third passes.

Next, the control section 30 causes the first operation and the second operation in the fourth pass to be performed. However, when the first operation and the second operation in the fourth pass are performed as they are, the movement direction in the first direction D1 in the fourth pass is opposite to the movement direction in the first direction D1 in the first pass with respect to the same pixel column formation region. As a result, there is a possibility that deviation of landing of ink with respect to the same pixel column formation region will occur.

For this reason, in the present variation, the control section 30 causes the recording medium B to move along the second direction D2 by a predetermined amount in the third pass, and then causes the recording medium B to move along the first direction D1 in the direction opposite to that in the third pass. At this time, no ink is discharged, and only the movement is performed. Thus, the movement direction in the first direction D1 in the fourth pass becomes the same direction as the movement direction in the first direction D1 in the first pass, and it is possible to suppress deviation of landing of ink with respect to the same pixel column formation region.

As described above, after the third pass, the control section 30 causes the recording medium B to move in the first direction D1 which is the opposite direction to that in the third pass. For this reason, as the movement operation in the fourth to sixth passes, the control section 30 causes the same movement operation to be performed as that in the first to third passes.

Next, the control section 30 causes the first operation and the second operation in the fourth to sixth passes to be performed sequentially. The first operation and the second operation in the fourth to sixth passes are the same as the first operation and the second operation in the first to third passes, respectively. It is configured, however, such that the nozzle 1-1 also discharges the ink and the pixels of pixel columns are formed in the same pixel column formation region by different adjacent nozzles 40. Thus, the pixels in each of the fourth to sixth passes are formed in the part of the pixel column formation region, in which no pixels have been formed, in the pixel columns in each of the first to third passes, thereby completing the pixel columns.

By performing the first operation and the second operation in the first to sixth passes described above, an image region is formed in a predetermined region as illustrated in the sixth pass of Fig. 8B.

In a case where the pixel columns in the next seventh pass and subsequent passes are formed after the formation of the pixel columns in the sixth pass, the control section 30 causes the recording medium B to move. Even here, the control section 30 causes the recording medium B to move in the second direction D2 which is the same direction as that in the first to sixth passes.

By repeatedly performing the above-described operations, a desired image, for example, a wiring pattern or the like is formed on the recording medium B.

By the operations described above, three adjacent pixel columns are formed in two stages by two adjacent nozzles 40. For this reason, even in a case where the print length is different between the heads 13A and 13B, it is possible to suppress the influence thereof, and it is possible to prevent gaps, streaks, and the like from occurring between the pixel columns adjacent to each other.

In addition, in the present variation as well, in the case of the movement in the second direction D2, the control section 30 causes the movement to occur in the same direction in all of the passes, and thus, there is no reversal of the movement direction. For this reason, there is no deterioration in the movement accuracy due to a structural play (backlash) of the movement mechanism of the drive section 20, and it is possible to prevent deterioration in the movement accuracy. As a result, it is possible to prevent a gap, a streak, or the like from occurring between the pixel columns adjacent to each other.

In addition, even in a case where the number of passes between nozzles is an odd number, it is possible to suppress deviation of landing of ink with respect to the same pixel column formation region since the movement directions in the first direction D1 with respect to the same pixel column formation region are caused to be the same (aligned) by performing only the movement.

### <Variation 3>

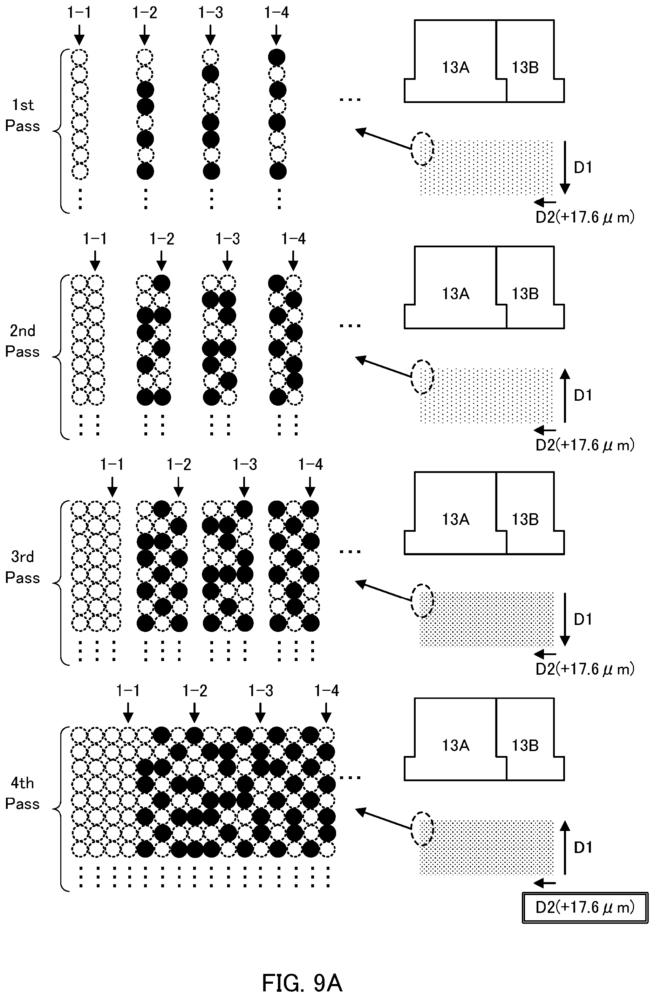

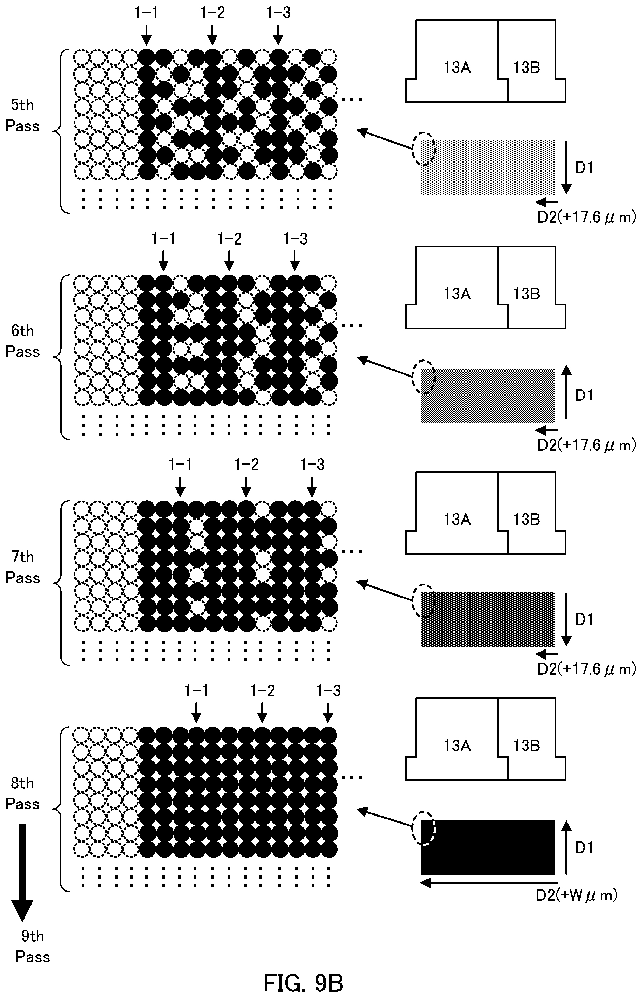

Fig. 9A is a diagram provided for describing another variation of the image forming method according to the present embodiment, which describes the first to fourth passes. Fig. 9B is a diagram provided for describing the other variation of the image forming method according to the present embodiment, which describes the fifth to eighth passes. Here, a method in which the block printing and the feathering are combined will also be described.

In addition, in Figs. 9A and 9B, the figures illustrated on the left and right are the same as those in Figs. 4A and 4B, and the reference sign "1-1" and the like are also as described in Figs. 4A and 4B. In addition, it is assumed that the number of nozzles in each of the heads 13A and 13B is also p.

In addition, a case in which an image with a print resolution of 1440 dpi is formed by performing four-pass block printing using the carriage 12 illustrated in Fig. 2B, specifically, using the heads 13A and 13B with a nozzle density of 360 dpi, will also be described here.

First, the control section 30 causes the first operation of the first pass to be performed. For example, the control section 30 uses the nozzles 40 of the heads 13A and 13B to discharge ink while moving the heads 13A and 13B along the first direction D1 in a state in which the recording medium B is stationary, thereby forming pixel columns in the pixel column formation region of the first pass. At this time, the control section 30 causes the pixel columns to be formed without discharge of the ink to part of the pixel column formation region of the first pass. Further, in the present variation as well, the discharge of ink is prohibited in the nozzle 1-1, which is the nozzle 40 at one end portion, and no pixel column formation is performed.

Thus, pixel columns for 2 × p-1 columns spaced apart by an interval corresponding to the nozzle pitch are formed on the recording medium B except for the pixel column formation region corresponding to the nozzle 1-1. In each pixel column, not all pixels but some pixels are formed. When p = 1024, that is, when the number of nozzles of each of the heads 13A and 13B is 1024, an image region is formed by pixel columns for 2 × 1024-1 = 2047 columns.

After the pixel columns in the first pass are formed, the control section 30 causes the second operation to be performed, and, for example, causes the recording medium B to be moved by a predetermined amount along the second direction D2. Here, since four-pass block printing is performed, the predetermined amount is a distance obtained by dividing the distance between the nozzle pitches into quarters, for example, is 17.6 µm.

Next, the control section 30 causes the first operation and the second operation in the second pass to be performed. The first operation and the second operation in the second pass are the same as the first operation and the second operation in the first pass except for the movement direction in the first direction D1. In the second pass, the movement direction in the first direction D1 is opposite to that in the first pass. Thus, on the recording medium B, except for the pixel column formation region corresponding to the nozzle 1-1, pixel columns in the second pass are formed adjacent to the pixel column formed in the first pass.

Next, the control section 30 causes the first operation and the second operation in the third pass to be performed. The first operation and the second operation in the third pass are the same as the first operation and the second operation in the first pass, including the movement direction in the first direction D1. Thus, on the recording medium B, except for the pixel column formation region corresponding to the nozzle 1-1, pixel columns in the third pass are formed adjacent to the pixel column formed in the second pass.

Next, the control section 30 causes the first operation and the second operation in the fourth pass to be performed. The first operation and the second operation in the fourth pass are the same as the first operation and the second operation in the second pass, including the movement direction in the first direction D1. Thus, on the recording medium B, except for the pixel column formation region corresponding to the nozzle 1-1, pixel columns in the fourth pass are formed adjacent to the pixel column formed in the third pass. By the first operation in the fourth pass, the image formation of pixel columns between the nozzle pitches is completed except for the pixel column formation region corresponding to the nozzle 1-1.

In the embodiment and Variation 1 described above, the movement directions in the first direction D1 are all the same, whereas it is configured here such that the movement directions in the first direction D1 are alternately reversed in the first to fourth passes.

In Variation 3, since the number of passes between nozzles is an odd number, there is an operation of only the movement, whereas here, since the number of passes between nozzles is an even number, the movement direction in the first direction D1 in the fourth pass is the same direction as the movement direction in the first direction D1 in the first pass. For this reason, an operation of only the movement is not required.

Next, the control section 30 causes the first operation and the second operation in the fifth to eighth passes to be performed sequentially. The first operation and the second operation in the fifth to eighth passes are the same as the first operation and the second operation in the first to fourth passes, respectively, but it is configured such that the nozzle 1-1 also discharges the ink and the pixels of pixel columns are formed in the same pixel column formation region by different adjacent nozzles 40. Thus, the pixels in each of the fifth to eighth passes are formed in the part of the pixel column formation region, in which no pixels have been formed, in the pixel columns in each of the first to fourth passes, thereby completing the pixel columns.

By performing the first operation and the second operation in the first to eighth passes described above, an image region is formed in a predetermined region as illustrated in the eighth pass of Fig. 9B.

In a case where the pixel columns in the next ninth pass and subsequent passes are formed after the formation of the pixel columns in the eighth pass, the control section 30 causes the recording medium B to move. Even here, the control section 30 causes the recording medium B to move in the second direction D2 which is the same direction as that in the first to eighth passes.

By repeatedly performing the above-described operations, a desired image, for example, a wiring pattern or the like is formed on the recording medium B.

By the operations described above, four adjacent pixel columns are formed in two stages by two adjacent nozzles 40. For this reason, even in a case where the print length is different between the heads 13A and 13B, it is possible to suppress the influence thereof, and it is possible to prevent gaps, streaks, and the like from occurring between the pixel columns adjacent to each other.

In addition, in the present variation as well, in the case of the movement in the second direction D2, the control section 30 causes the movement to occur in the same direction in all of the passes, and thus, there is no reversal of the movement direction. For this reason, there is no deterioration in the movement accuracy due to a structural play (backlash) of the movement mechanism of the drive section 20, and it is possible to prevent deterioration in the movement accuracy. As a result, it is possible to prevent a gap, a streak, or the like from occurring between the pixel columns adjacent to each other.

In addition, since the number of passes between nozzles is an even number, the movement direction in the first direction D1 with respect to the same pixel column formation region becomes the same, and it is possible to suppress deviation of landing of ink with respect to the same pixel column formation region.

### <Variation 4>

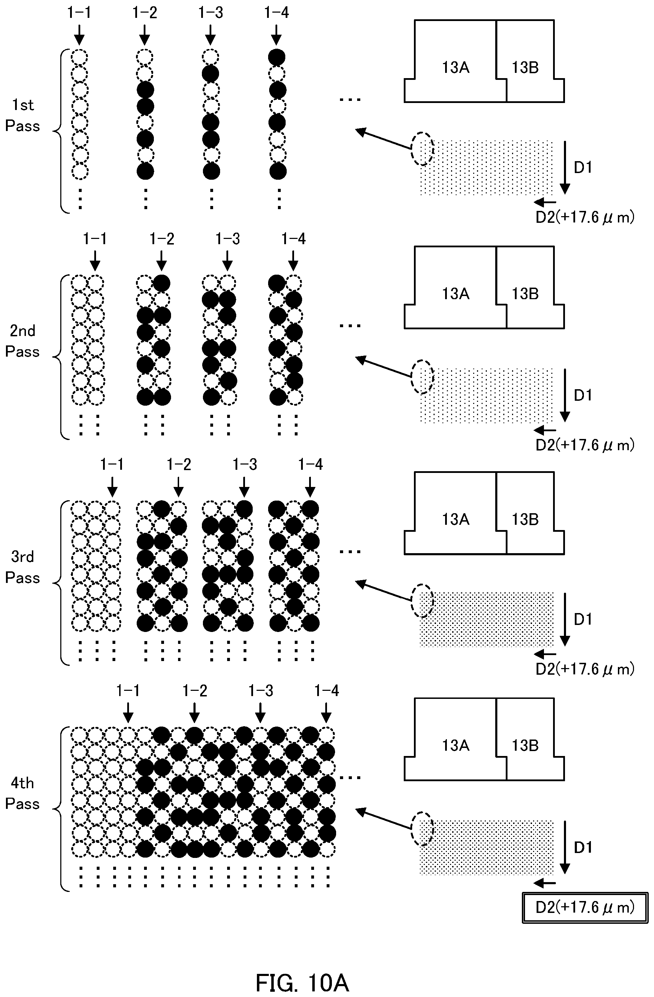

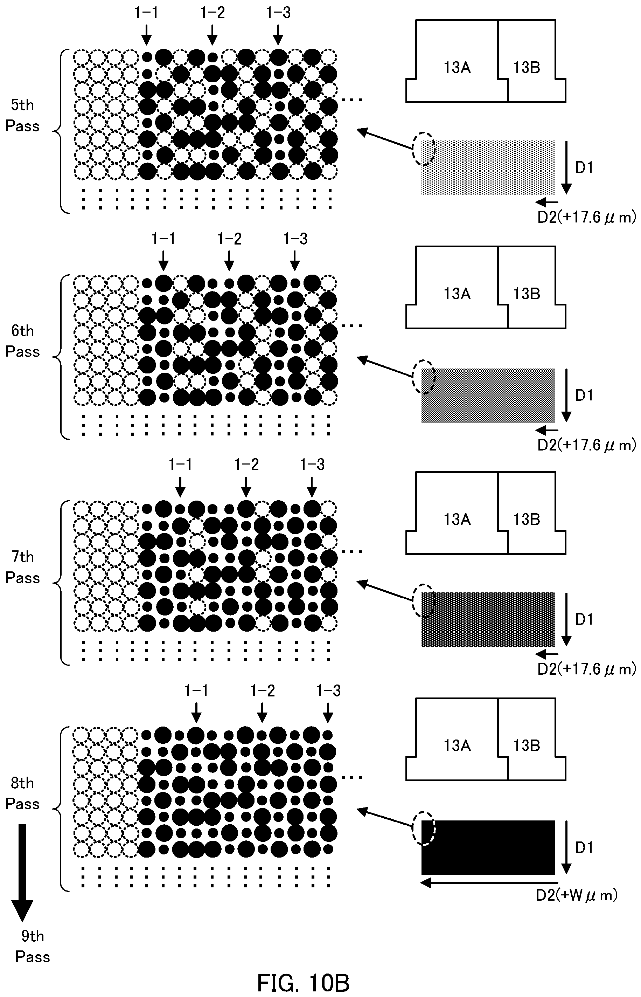

Fig. 10A is a diagram provided for describing another variation of the image forming method according to the present embodiment, which describes the first to fourth passes. Fig. 10B is a diagram provided for describing the other variation of the image forming method according to the present embodiment, which describes the fifth to eight passes. Here, a method in which the block printing and the feathering are combined will also be described.

In addition, in Figs. 10A and 10B, the figures illustrated on the left and right are the same as those in Figs. 4A and 4B, and the reference sign "1-1" and the like are also as described in Figs. 4A and 4B. In addition, it is assumed that the number of nozzles in each of the heads 13A and 13B is also p.

In addition, a case in which an image with a print resolution of 1440 dpi is formed by performing four-pass block printing using the carriage 12 illustrated in Fig. 2B, specifically, using the heads 13A and 13B with a nozzle density of 360 dpi, will also be described here.

First, the control section 30 causes the first operation of the first pass to be performed. For example, the control section 30 uses the nozzles 40 of the heads 13A and 13B to discharge ink while moving the heads 13A and 13B along the first direction D1 in a state in which the recording medium B is stationary, thereby forming pixel columns in the pixel column formation region of the first pass. At this time, the control section 30 causes the pixel columns to be formed without discharge of the ink to part of the pixel column formation region of the first pass. Further, in the present variation as well, the discharge of ink is prohibited in the nozzle 1-1, which is the nozzle 40 at one end portion, and no pixel column formation is performed.

Thus, pixel columns for 2 × p-1 columns spaced apart by an interval corresponding to the nozzle pitch are formed on the recording medium B except for the pixel column formation region corresponding to the nozzle 1-1. In each pixel column, not all pixels but some pixels are formed. When p = 1024, that is, when the number of nozzles of each of the heads 13A and 13B is 1024, an image region is formed by pixel columns for 2 × 1024-1 = 2047 columns.

After the pixel columns in the first pass are formed, the control section 30 causes the second operation to be performed, and, for example, causes the recording medium B to be moved by a predetermined amount along the second direction D2. Here, since four-pass block printing is performed, the predetermined amount is a distance obtained by dividing the distance between the nozzle pitches into quarters, for example, is 17.6 µm.

Next, the control section 30 causes the first operation and the second operation in the second to fourth passes to be performed sequentially. The first operation and the second operation in the second to fourth passes are the same as the first operation and the second operation in the first pass, including the movement direction in the first direction D1. Thus, on the recording medium B, except for the pixel column formation region corresponding to the nozzle 1-1, pixel columns in the second pass are formed adjacent to the pixel column formed in the first pass. Similarly, pixel columns in the third pass are formed adjacent to the pixel columns formed in the second pass, and pixel columns in the fourth pass are formed adjacent to the pixel columns formed in the third pass. By the first operation in the fourth pass, the image formation of pixel columns between the nozzle pitches is completed except for the pixel column formation region corresponding to the nozzle 1-1.

Next, the control section 30 causes the first operation and the second operation in the fifth to eighth passes to be performed sequentially. The first operation and the second operation in the fifth to eighth passes are basically the same as the first operation and the second operation in the first pass, including the movement direction in the first direction D1. It is configured, however, such that the nozzle 1-1 also discharges the ink and the pixels of pixel columns are formed in the same pixel column formation region by different adjacent nozzles 40. In addition, in the fifth to eighth passes, the droplet amount of the ink droplets to be discharged is changed from that in the first to fourth passes. Thus, the pixels in each of the fifth to eighth passes are formed in the part of the pixel column formation region, in which no pixels have been formed, in the pixel columns in each of the first to fourth passes, thereby completing the pixel columns.

By performing the first operation and the second operation in the first to eighth passes described above, an image region is formed in a predetermined region as illustrated in the eighth pass of Fig. 10B.

In the present variation, as an example, the droplet amounts of the ink droplets are changed to amounts different from each other between the first four first operations and the latter four first operations among eight (m × n = 8) first operations. The present invention is not limited thereto, and the droplet amount of the ink droplets may be changed to an amount different from the others in at least one or more first operations among a plurality of first operations.

In a case where the pixel columns in the next ninth pass and subsequent passes are formed after the formation of the pixel columns in the eighth pass, the control section 30 causes the recording medium B to move. Even here, the control section 30 causes the recording medium B to move in the second direction D2 which is the same direction as that in the first to eighth passes.

By repeatedly performing the above-described operations, a desired image, for example, a wiring pattern or the like is formed on the recording medium B.

By the operations described above, four adjacent pixel columns are formed in two stages by two adjacent nozzles 40. For this reason, even in a case where the print length is different between the heads 13A and 13B, it is possible to suppress the influence thereof, and it is possible to prevent gaps, streaks, and the like from occurring between the pixel columns adjacent to each other.

In addition, in the present variation as well, in the case of the movement in the second direction D2, the control section 30 causes the movement to occur in the same direction in all of the passes, and thus, there is no reversal of the movement direction. For this reason, there is no deterioration in the movement accuracy due to a structural play (backlash) of the movement mechanism of the drive section 20, and it is possible to prevent deterioration in the movement accuracy. As a result, it is possible to prevent a gap, a streak, or the like from occurring between the pixel columns adjacent to each other.

In addition, in the present variation, since the droplet amount of the ink droplets is changed between the passes, it is possible to adjust the film thickness of the image to be formed, without changing the droplet amount of the ink droplets in a pass. In addition, since the droplet amount of the ink droplets is not changed in a pass, the drive waveform for discharging the ink is not switched to a different drive waveform in a pass and it is possible to suppress variations in the droplet speed or the like due to the switching of the drive waveform, and as a result, it is possible to suppress deviation of landing.

The embodiment and variations described above are merely examples for implementing the present invention, and the technical scope of the present invention should not be interpreted in a limited manner thereby. That is, the present invention can be implemented in various forms without departing from the spirit or main features thereof.

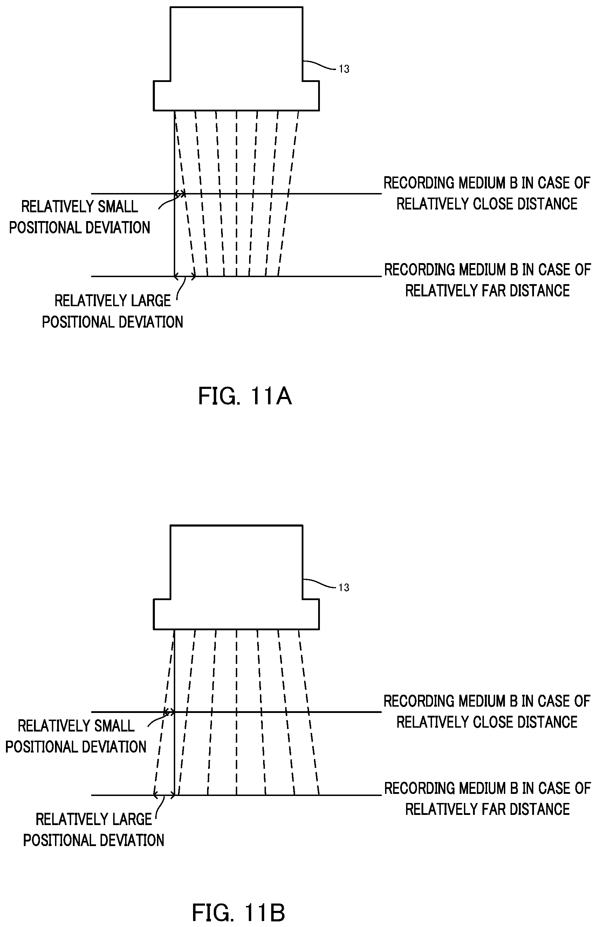

For example, Fig. 11A is a diagram illustrating how ink to be discharged from each nozzle of the head 13 is ejected so as to be narrowed inward. Fig. 11B is a diagram illustrating how ink to be discharged from each nozzle of the head 13 is ejected so as to spread outward. In Figs. 11A and 11B, the broken lines indicate the direction of the ink to be ejected.

As illustrated in Figs. 11A and 11B, in a case where the ink to be ejected from nozzles is angled in the head 13 as a whole, the landing position of the ink deviates from the target position depending on the distance between the nozzles and the recording medium B. This deviation increases as the distance between the discharge ports of the nozzles and the recording medium B increases.

For this reason, in a case where the angle of the ink to be ejected from the nozzles of the head 13 as a whole is greater than a predetermined angle, or in a case where the distance between the recording medium B and the discharge ports of the nozzles is greater than a predetermined distance, the control section 30 adopts the printing operations in the embodiment or variations described above. This is because the same nozzles form adjacent pixels in the image region formed by the same head 13, and thus, even when the ejection angle of the ink from the nozzles is biased, the deviation becomes smaller.

The disclosure of Japanese Patent Application No. 2023-143541, filed on September 5, 2023, including the specification, drawings and abstract, is incorporated herein by reference in its entirety.

### Reference Signs List

1 Image forming apparatus
11 Placement base
12 Carriage
13, 13A, 13B Inkjet head
20 Drive section
21 Motor
30 Control section
40 Nozzle
41 Nozzle column
42 Head chip module
50 Irradiation section

## Claims

1. An image forming apparatus, comprising:
a head section that causes a plurality of nozzles to discharge ink, the plurality of nozzles being arranged in a row at each nozzle pitch along a second direction orthogonal to a first direction; and
a control section that causes a first operation and a second operation to be repeatedly performed to perform control such that an image with the ink is formed in a nozzle pitch corresponding region of a recording medium, the first operation being an operation in which the ink is discharged while relatively moving the recording medium and the head section in the first direction, the second operation being an operation in which the recording medium and the head section are relatively moved in the second direction, the nozzle pitch corresponding region corresponding to the each nozzle pitch, wherein
in a case where the first operation is performed n times with respect to each of m pixel column formation regions obtained by dividing the nozzle pitch corresponding region into the m pixel column formation regions in the second direction, the control section prohibits discharge of the ink in at least one of the plurality of nozzles from a side of an end portion of the head section in at least one of a plurality of the first operations when the second operation in which the recording medium and the head section are moved in one direction to one side in the second direction is performed m × n times, n is an integer equal to or greater than 2, m is an integer equal to or greater than 1.

2. The image forming apparatus according to claim 1, wherein
the control section prohibits, in each of first m first operations among the plurality of first operations, the discharge of the ink in n-1 nozzles among the plurality of nozzles, the n-1 nozzles being nozzles from an end portion of the head section on another side in the second direction.

3. The image forming apparatus according to claim 2, wherein
the control section prohibits, in each of last m first operations among the plurality of first operations, the discharge of the ink in n-1 nozzles among the plurality of nozzles, the n-1 nozzles being nozzles from an end portion of the head section on the one side in the second direction.

4. The image forming apparatus according to claim 1, wherein
in a case where the plurality of nozzles includes a nozzle unusable in the head section, the control section performs control such that the ink is discharged to the m pixel column formation regions by using the plurality of nozzles except for the nozzle unusable in the head section.

5. The image forming apparatus according to claim 1, wherein
the head section includes a plurality of nozzle columns.

6. The image forming apparatus according to claim 1, wherein
the ink is a single type of ink.

7. The image forming apparatus according to claim 1, wherein
the recording medium is a circuit board.

8. The image forming apparatus according to claim 1, wherein
in a case where movement directions in the plurality of first operations are alternately reversed and m is an odd number, the control section causes a first operation among the plurality of first operation to be performed to align the movement directions in the m first operation with respect to a same pixel column formation region among the m pixel column formation regions, the first operation being an operation in which the ink is not discharged.

9. The image forming apparatus according to claim 1, wherein
the head section changes a droplet amount of the ink to be discharged in at least one of the m × n first operations.

10. The image forming apparatus according to claim 1, wherein
the head section includes a plurality of heads each of which is composed of one nozzle column.

11. The image forming apparatus according to claim 10, wherein
an end portion of the one nozzle column of a head among the plurality of heads includes an image formation region overlapping with the nozzle column of a head adjacent to the head among the plurality of heads.

12. The image forming apparatus according to claim 1, further comprising:
a drive section that executes the first operation and the second operation, wherein
the drive section includes a motor including a rotation shaft, a coil, and an electromagnet.

13. The image forming apparatus according to claim 1, wherein
the ink is ink that is cured by irradiation with an energy ray.

14. The image forming apparatus according to claim 13, wherein
the energy ray is an ultraviolet ray.

15. The image forming apparatus according to claim 1, wherein
the ink includes a gelling agent.

16. The image forming apparatus according to claim 7, wherein:
the circuit board includes: an insulating board; and a wiring conductor disposed on the insulating board, and
the ink is solder resist ink.

17. The image forming apparatus according to claim 1, wherein
the ink is ink having a thermosetting property.

18. An image forming method, comprising
repeatedly performing, by an image forming apparatus including a head section that causes a plurality of nozzles to discharge ink, a first operation and a second operation to form an image with the ink in a nozzle pitch corresponding region of a recording medium, the plurality of nozzles being arranged in a row at each nozzle pitch along a second direction orthogonal to a first direction, the first operation being an operation in which the ink is discharged while relatively moving the recording medium and the head section in the first direction, the second operation being an operation in which the recording medium and the head section are relatively moved in the second direction, the nozzle pitch corresponding region corresponding to the each nozzle pitch, wherein
in a case where the first operation is performed n times with respect to each of m pixel column formation regions obtained by dividing the nozzle pitch corresponding region into the m pixel column formation regions in the second direction, discharge of the ink in at least one of the plurality of nozzles from a side of an end portion of the head section is prohibited in at least one of a plurality of the first operations when the second operation in which the recording medium and the head section are moved in one direction to one side in the second direction is performed m × n times, n is an integer equal to or greater than 2, m is an integer equal to or greater than 1.

19. An image forming program, which causes a computer to execute, in an image forming apparatus including a head section that causes a plurality of nozzles to discharge ink, repeatedly performing a first operation and a second operation to form an image with the ink in a nozzle pitch corresponding region of a recording medium, the plurality of nozzles being arranged in a row at each nozzle pitch along a second direction orthogonal to a first direction, the first operation being an operation in which the ink is discharged while relatively moving the recording medium and the head section in the first direction, the second operation being an operation in which the recording medium and the head section are relatively moved in the second direction, the nozzle pitch corresponding region corresponding to the each nozzle pitch, wherein
the image forming program causes the computer to execute, in a case where the first operation is performed n times with respect to each of m pixel column formation regions obtained by dividing the nozzle pitch corresponding region into the m pixel column formation regions in the second direction, prohibiting discharge of the ink in at least one of the plurality of nozzles from a side of an end portion of the head section in at least one of a plurality of the first operations when the second operation in which the recording medium and the head section are moved in one direction to one side in the second direction is performed m × n times, n is an integer equal to or greater than 2, m is an integer equal to or greater than 1.
